# EUROPEAN PATENT APPLICATION

(11) **EP 4 503 108 A1**
(43) Date of publication of application: **05.02.2025**
(21) Application number: 22933506.2
(22) Date of filing: 25.03.2022
(51) Int. Cl.: H01L 21/683

(54) **CORRECTION APPARATUS, EXPOSURE APPARATUS, COATER/DEVELOPER APPARATUS, EXPOSURE SYSTEM, EXPOSURE METHOD, AND DEVICE MANUFACTURING METHOD**

(71) Applicant: NIKON CORPORATION, Tokyo 140-8601 (JP)
(72) Inventor: ICHINOSE, Go, Tokyo 108-6290 (JP)
(74) Representative: Hoffmann Eitle
(86) International application number: PCT/JP2022/014471
(87) International publication number: WO 2023/181367

(57) **Abstract**

A correction apparatus includes a mounting device configured to allow a wafer to be mounted thereon, a heating part configured to heat the wafer mounted on the mounting device, a force application part configured to apply a force to the wafer mounted on the mounting device, a first transport device configured to transport the wafer removed from the mounting device, and a controller configured to control the heating part and the force application part, wherein the controller performs shape correction on the wafer by the force application part applying a force to the wafer while the heating part heats the wafer, and the first transport device transports the wafer to which the shape correction has been performed.

## Description

### [Technical Field]

The present invention relates to a correction apparatus, an exposure apparatus, a coater and developer apparatus, an exposure system, an exposure method, and a device manufacturing method.

### [Background Art]

Conventionally, a correction apparatus for correcting a warped wafer is known.

### [Citation List]

### [Patent Document]

[Patent Document 1]
United States Patent Application, Publication No. 2016/0322234

### [Summary of Invention]

### [Solution to Problem]

A correction apparatus according to a first aspect of the present invention includes a mounting device configured to allow a wafer to be mounted thereon, a heating part configured to heat the wafer mounted on the mounting device, a force application part configured to apply a force to the wafer mounted on the mounting device, a first transport device configured to transport the wafer removed from the mounting device, and a controller configured to control the heating part and the force application part, in which the controller performs shape correction on the wafer by causing the force application part to apply a force to the wafer while the heating part heats the wafer, and the first transport device transports the wafer to which the shape correction has been performed.

A correction apparatus according to a second aspect of the present invention includes a mounting device configured to allow a wafer to be mounted thereon, a heating part configured to heat the wafer mounted on the mounting device, and a force application part configured to apply a force to the wafer, in which the force application part applies a force to the wafer so that the wafer is aligned with the mounting device while the heating part heats the wafer, thereby correcting a shape of the wafer.

A correction apparatus according to a third aspect of the present invention includes a reference member that has a reference surface, a heating part configured to heat a wafer, and a force application part configured to apply a force to the wafer by applying a force to the wafer so that the wafer is aligned with the reference surface.

A correction apparatus according to a fourth aspect of the present invention includes a measurement part configured to measure a three-dimensional shape of a wafer, a holding part configured to hold a center of the wafer, a heating part configured to heat the wafer, a force application part configured to apply a force to an outer periphery of the wafer in a first direction, and a controller configured to control the heating part and the force application part, in which the controller causes the force application part to apply a force to the outer periphery of the wafer on the basis of the three-dimensional shape measured by the measurement part while the heating part heats the wafer, thereby deforming the wafer.

A correction apparatus according to a fifth aspect of the present invention includes a measurement part configured to measure a three-dimensional shape of a wafer, a holding part configured to hold a first portion of the wafer, a heating part configured to heat the wafer, a force application part configured to apply a force to deform a second portion of the wafer, that is outside the first portion, in a first direction, and a controller configured to control the heating part and the force application part, in which the controller applies a force to the wafer by causing the force application part to apply a force to the second portion of the wafer on the basis of the three-dimensional shape measured by the measurement part while the heating part heats the wafer.

A correction apparatus according to a sixth aspect of the present invention includes a holding part configured to hold a center of a wafer, a heating part configured to heat the wafer, and a force application part configured to apply a force to the wafer by applying the force to an outer periphery of the wafer in a first direction of the wafer.

A correction apparatus according to a seventh aspect of the present invention includes a holding part configured to hold a side surface of a wafer, a heating part configured to heat the wafer, and a force application part configured to deform the wafer by applying a force to the wafer via the holding part.

A correction apparatus according to an eighth aspect of the present invention includes a holding part configured to hold a side surface of a wafer in a first direction, a heating part configured to heat the wafer, and a force application part configured to apply a force to the wafer by applying a force to the wafer.

A correction apparatus according to a ninth aspect of the present invention includes a measurement part configured to measure a shape of a wafer, a heating part configured to heat the wafer, a force application part configured to apply a force to the wafer by applying a force to the wafer, and a controller configured to control the heating part and the force application part, in which the controller performs control so that the force application part applies different forces at different positions on the surface of the wafer on the basis of the shape of the wafer measured by the measurement part while the heating part heats the wafer, or performs control so that the force application part applies forces with different pushing amounts at different positions on the surface of the wafer.

A correction system according to a first aspect of the present invention includes the correction apparatus according to any one of the aspects, a coating device capable of coating a photosensitive agent on a wafer, and an exposure apparatus configured to expose a wafer coated with the photosensitive agent using an energy beam.

An exposure method according to a first aspect of the present invention is an exposure method of exposing a wafer using an energy beam, and includes exposing the wafer whose shape has been corrected by the correction apparatus according to any one of the aspects using the energy beam.

A device manufacturing method according to a first aspect of the present invention is a device manufacturing method including an exposure step, in which the exposure step includes developing the wafer exposed using the exposure system according to any one of the aspects.

### [Brief Description of Drawings]

FIG. 1 is a perspective view of an umbrella-shaped warped wafer used in an exposure system according to a first embodiment of the present invention.
FIG. 2 is a perspective view of the same wafer warped into a Frisbee shape.
FIG. 3 is a perspective view of the same wafer warped into a parabolic shape.
FIG. 4 is a perspective view of the same wafer warped into a saddle shape.
FIG. 5 is a cross-sectional view for describing an example of a method of measuring an amount of warping of the same wafer.
FIG. 6 is a plan view which shows a model of the same exposure system.
FIG. 7 is a schematic diagram which shows the same exposure system.
FIG. 8 is a cross-sectional view of a part of a correction apparatus of the same exposure system.
FIG. 9 is a plan view which shows a part of a measurement part of the same correction apparatus through transmission.
FIG. 10 is a cross-sectional view taken along a cutting line A1-A1 in FIG. 9.
FIG. 11 is a plan view of a mounting device of the same correction apparatus.
FIG. 12 is a cross-sectional view of the same wafer corrected into an umbrella-shape.
FIG. 13 is a cross-sectional view of a part of a correction apparatus of a first modified example of the first embodiment of the present invention.
FIG. 14 is a cross-sectional view of a correction apparatus of a fourth modified example of the first embodiment of the present invention.
FIG. 15 is a cross-sectional view of a correction apparatus of a fifth modified example of the first embodiment of the present invention.
FIG. 16 is a cross-sectional view of a correction apparatus of a sixth modified example of the first embodiment of the present invention.
FIG. 17 is a plan view of a correction apparatus of a second embodiment of the present invention.
FIG. 18 is a plan view of a correction apparatus of a third embodiment of the present invention.
FIG. 19 is a cross-sectional view taken along a cutting line A2-A2 of FIG. 18.

### (First embodiment)

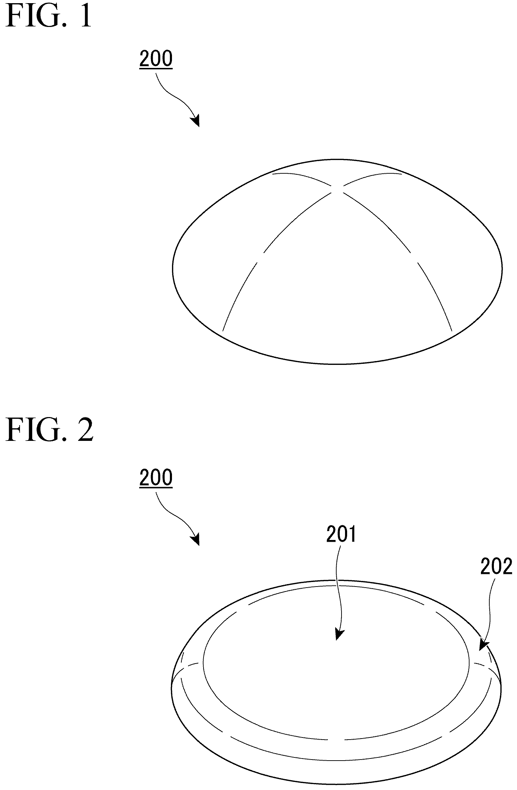

Hereinafter, a first embodiment of a correction apparatus and an exposure system according to the present invention will be described with reference to FIG. 1 to 16.

In the following description, a wafer 200 that is carried into the correction apparatus will be described using FIG. 1. Note that in the following drawings, an amount of warping of the wafer 200 is shown to be greater than an actual amount of warping.

The wafer 200 without warpage has a circular flat plate shape in a plan view. The wafer 200 is disposed along a horizontal surface. The wafer 200 shown in FIG. 1 is warped in a so-called umbrella shape. In the umbrella-shaped wafer 200, the wafer 200 is disposed so that it gradually slopes downward from a center of the wafer 200 toward the outer edge in a plan view.

A warpage shape of the wafer 200 is not limited to an umbrella-shape.

The wafer 200 shown in FIG. 2 is warped in a so-called Frisbee shape. In the Frisbee-shaped wafer 200, a center 201 of the wafer 200 is flat in a plan view. An outer periphery 202 of the wafer 200 surrounding the center 201 is disposed so as to gradually slope downward toward the outer edge. In other words, in the Frisbee-shaped wafer 200, a local curvature of the outer periphery 202 is larger than a local curvature of the center 201. In other words, in the Frisbee-shaped wafer 200, a local radius of the curvature of the outer periphery 202 is smaller than a local radius of the curvature of the center 201.

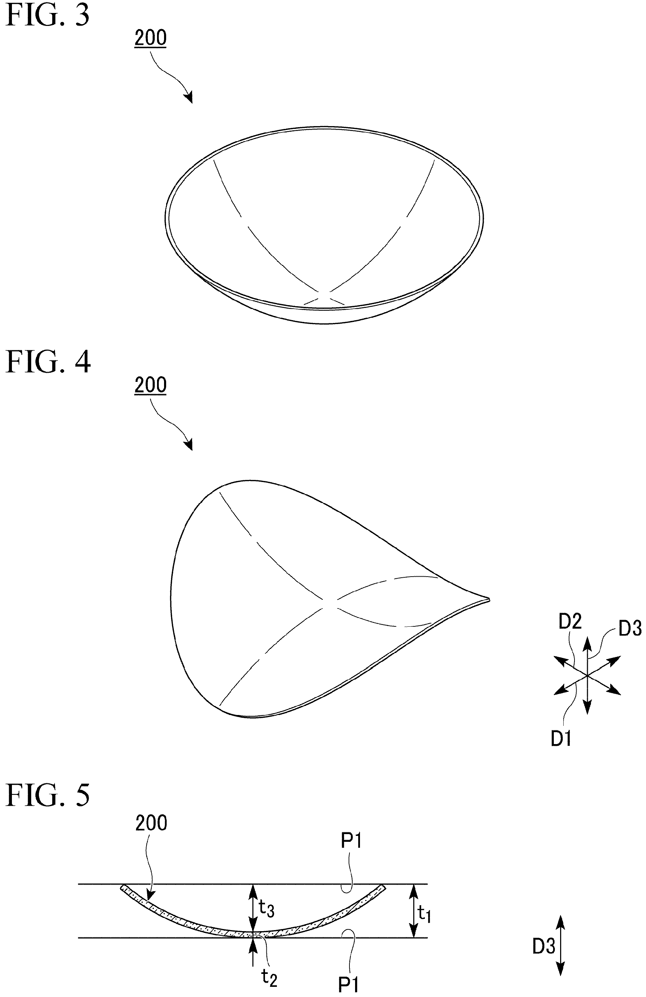

The wafer 200 shown in FIG. 3 is warped in a so-called parabolic shape. In the parabolic-shaped wafer 200 having a downward convex (convex downward), the wafer 200 is disposed so that it gradually moves upward from the center of the wafer 200 toward the outer edge in a plan view.

The wafer 200 shown in FIG. 4 is warped in a so-called saddle shape. Here, the directions that are orthogonal to a thickness direction (a first direction) (hereinafter simply referred to as a thickness direction) D3 of the wafer 200 and intersect with each other are defined as a first orthogonal direction (a second direction) D1 and a second orthogonal direction (a third direction) D2. Note that the thickness direction D3 is generally a direction in which gravitational acceleration acts on the wafer 200.

In the saddle-shaped wafer 200, a part located in a first orthogonal direction D1 with respect to the center of the wafer 200 in a plan view is disposed so that it gradually moves downward from the center toward the outer edge. A part located in a second orthogonal direction D2 with respect to the center of the wafer 200 in a plan view is disposed so that it gradually moves upward from the center toward the outer edge.

Note that the wafer 200 may have a smaller dimension in a cross direction (a fourth direction) that crosses each of the first orthogonal direction D1 and the second orthogonal direction D2 than dimensions along the first orthogonal direction D1 and the second orthogonal direction D2. The cross direction is a direction orthogonal to the thickness direction D3.

Here, an example of a method of measuring the amount of warping of the wafer 200 will be described.

As shown in FIG. 5, a pair of planes P1 that are completely flat and disposed parallel to each other are used to measure the amount of warping of the wafer 200. The wafer 200 is sandwiched between the pair of planes P1 in the thickness direction D3. At this time, a distance between the pair of planes P1 is a flatness t₁. A value obtained by subtracting a thickness t₂ of the wafer 200 from the flatness t₁ is the amount of warping t₃ of the wafer 200.

For example, the flatness t₁ of the pair of planes P1 is measured as follows. At a position radially outward from the wafer 200, the distance (flatness) between the pair of planes P1 is measured using a micrometer or the like. This measurement is performed at a plurality of locations (for example, six locations) at equal angles in a circumferential direction of the wafer 200. An average value of the plurality of measurements of flatness is defined as the flatness t₁.

For example, the thickness t₂ of the wafer 200 is measured as follows. The thickness of the wafer 200 is measured using a micrometer or the like at a position half a radius from the center of the wafer 200 toward the radially outer side. This measurement is performed at a plurality of locations (for example, six locations) at equal angles in the circumferential direction of the wafer 200. The average value of the thicknesses of the wafer 200 measured a plurality of times is defined as the thickness t₂ of the wafer 200.

The method of measuring the amount of warping of the wafer 200 is not limited to the method described with reference to FIG. 5.

Next, the exposure system will be described. In the following description, an X-axis and a Y-axis that are orthogonal to each other are defined and a Z-axis is defined in a direction orthogonal to the X-axis and the Y-axis in a plane that is substantially parallel to a horizontal plane. The plane defined by the X-axis and the Y-axis does not have to be substantially horizontal.

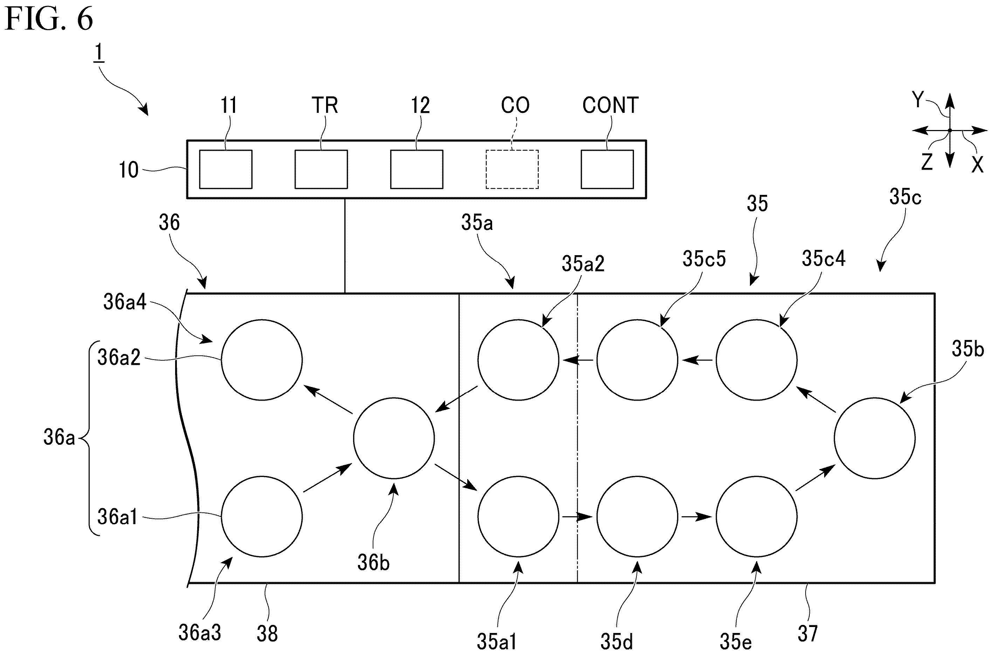

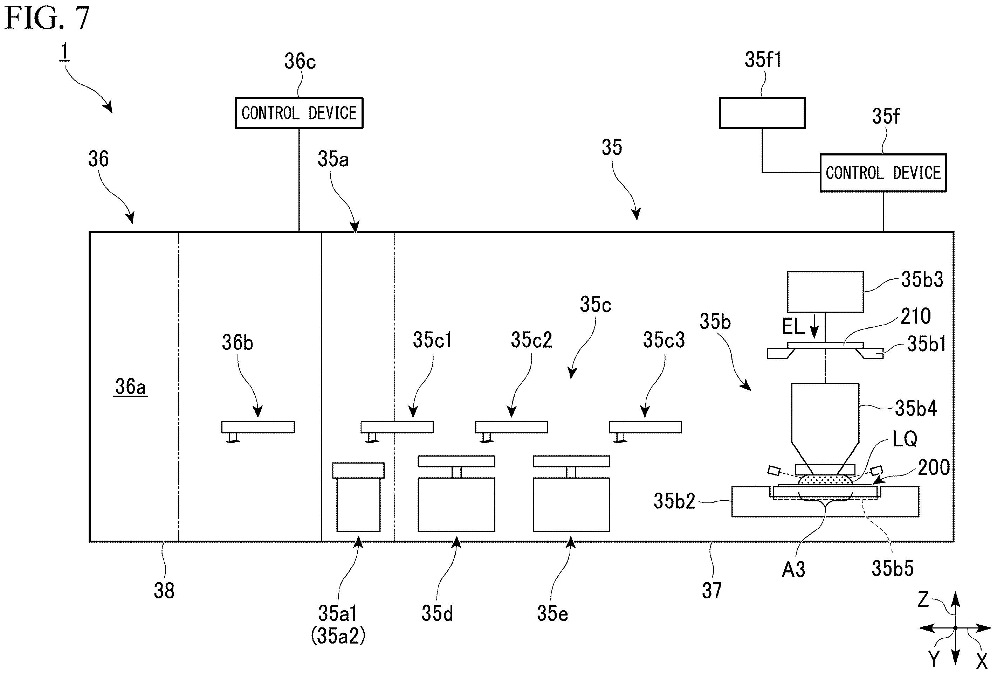

As shown in FIGS. 6 and 7, the exposure system 1 of the present embodiment includes a correction apparatus 10 of the present embodiment, an exposure apparatus 35, and a coater and developer apparatus 36.

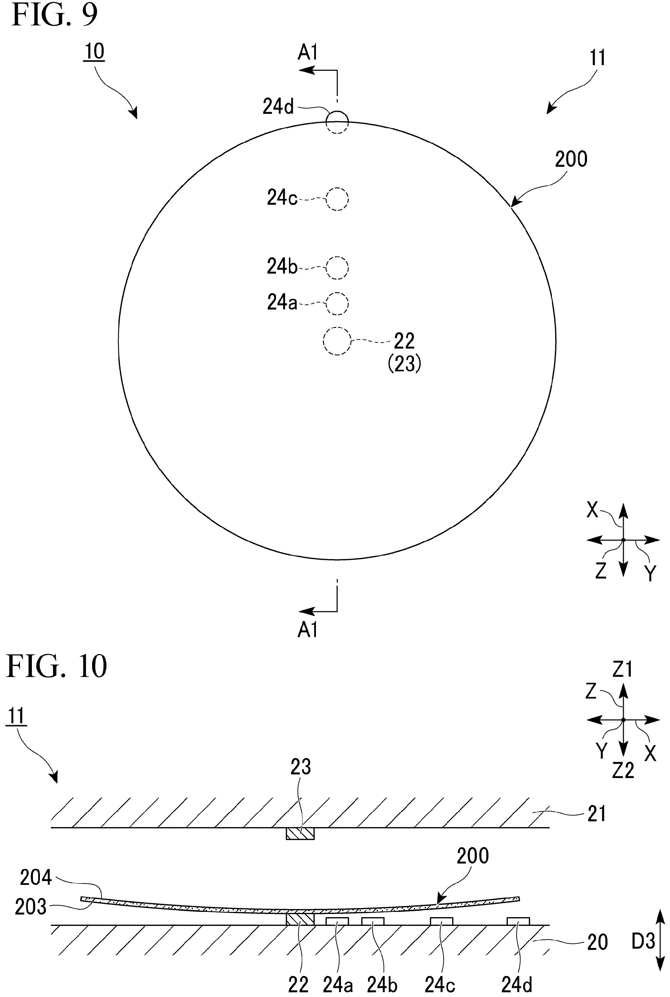

As shown in FIGS. 6, 8, 9, and 10, the correction apparatus 10 includes a measurement part 11, a mounting device 12, a heating part 13, a force application part 14, a transport device TR, and a controller CONT. In addition, FIG 9 shows a first frame 20, a second frame 21, and the like, which will be described below, through transmission.

The measurement part 11 is not particularly limited as long as it measures a three-dimensional shape of the wafer 200 (the shape of the wafer). As shown in FIG. 9 and FIG. 10, in the present embodiment, the measurement part 11 has a first frame 20, a second frame 21, a holding part 22, a first sensor 23, and second sensors 24a, 24b, 24c, and 24d.

As shown in FIG. 10, the first frame 20 and the second frame 21 are disposed to face each other. For example, the first frame 20 and the second frame 21 are disposed to face each other in a vertical direction.

The holding part 22 is fixed to the first frame 20. For example, the holding part 22 holds the wafer 200 by suction or the like. The holding part 22 holds a first surface (a lower surface) 203 of the wafer 200, which faces a first side in the thickness direction D3. The holding part 22 holds a center of the first surface 203. The holding part 22 rotates the wafer 200 around a central axis of the wafer 200. In this example, the thickness direction D3 and the central axis of the wafer 200 are parallel to the Z-axis, and the first surface 203 of the wafer 200 held by the holding part 22 faces a Z2 direction. A second surface 204 of the wafer 200 held by the holding part 22 faces a Z1 direction to face the second frame 21.

For example, the first sensor 23 and the second sensors 24a, 24b, 24c and 24d are sensors for measuring a position of a specific portion of the wafer 200 without contact. Types of the first sensor 23 and the second sensors 24a, 24b, 24c, and 24d are not limited.

The first sensor 23 is fixed to the second frame 21 so as to face the holding part 22. The second sensors 24a, 24b, 24c, and 24d are fixed to the first frame 20 at different positions in a radial direction of the wafer 200.

In this example, the second sensors 24a, 24b, 24c, and 24d are disposed along the X-axis, but they do not have to be disposed on the same line. All of the second sensors 24a, 24b, 24c, and 24d may be fixed to the first frame 20, or some of the second sensors 24a, 24b, 24c, and 24d may be fixed to the first frame 20 and the rest may be fixed to the second frame 21.

For example, the first sensor 23 measures a position in the thickness direction D3 of a center of the second surface (a top surface) 204 facing a second side opposite to the first side in the thickness direction D3. The position in the thickness direction D3 may be called a height.

The thickness of the wafer 200 is measured based on a measurement result of the first sensor 23. Note that, the second surface 204 of the wafer is generally a process surface on which various elements are formed. The first surface 203 and the second surface 204 are surfaces each facing the thickness direction D3.

The second sensors 24a, 24b, 24c, and 24d measure positions of each radial part of the first surface 203 of the wafer 200 in the thickness direction D3.

While the holding part 22 rotates the wafer 200 around a central axis, the second sensors 24a, 24b, 24c, and 24d each measure the position of the second surface 204 in the thickness direction D3, thereby measuring the three-dimensional shape of the wafer 200. The measurement part 11 also measures the amount of warping of the wafer 200.

**In** this example, the first sensor 23 and the second sensors 24a, 24b, 24c, and 24d are capacitance sensors, but they may be induction sensors or optical sensors including a light receiving unit. The first sensor 23 and the second sensors 24a, 24b, 24c, and 24d may be different types of sensors.

The measurement part **11** may measure the three-dimensional shape of the wafer 200 by, for example, acquiring an image of the wafer 200 with a camera. The three-dimensional shape of the wafer 200 may be measured by, for example, acquiring an image of the wafer 200 with a stereo camera, and analyzing the image.

The measurement part **11** may use a three-dimensional (3D) scanner to measure the three-dimensional shape of the wafer 200. For example, the 3D scanner may project a lattice pattern onto the wafer 200, and capture and analyze the shape of the projection pattern, thereby measuring the three-dimensional shape. Alternatively, the measurement part 11 may irradiate the wafer 200 with a slit laser light, receive the reflected light, and obtain distance information to the wafer 200 using a principle of triangulation or a principle of Time of Flight (ToF), thereby acquiring the three-dimensional shape of the wafer 200.

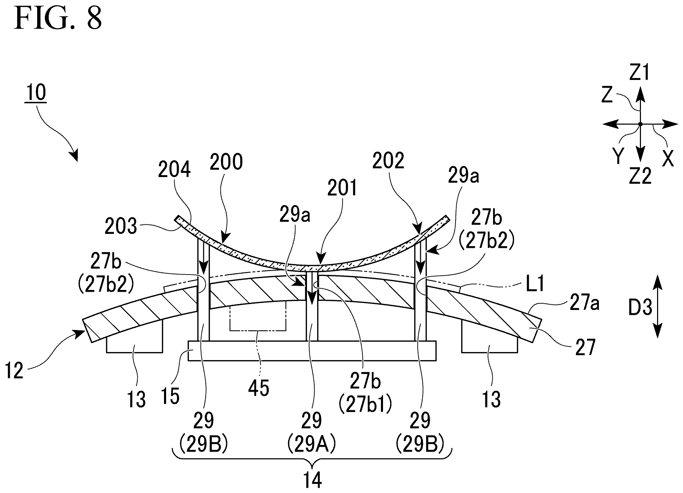

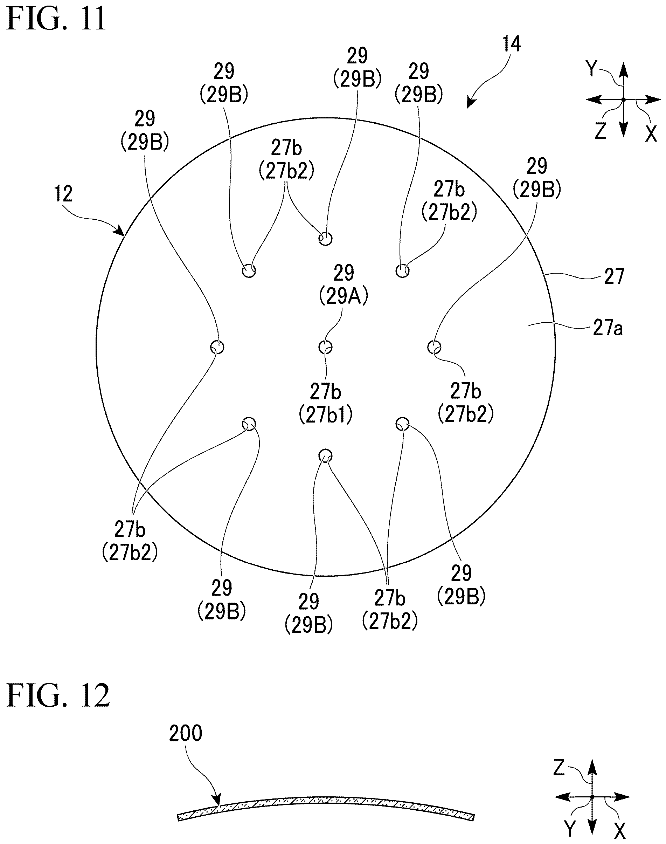

As shown in FIG. 8, the mounting device 12 mounts the wafer 200. As shown in FIG. 8 and FIG. 11, the mounting device 12 includes a reference member 27 having a reference surface (a mounting surface, a top surface) 27a. In this example, the reference member 27 has a circular shape in a plan view. The reference surface 27a is curved to be convex upward around an entire circumference of the reference surface 27a. In other words, a shape of the reference surface 27a of the mounting device 12 is a shape of a convex part.

The shape of this reference surface 27a is designed on the basis of deformation caused by a reaction force after the force application part 14 applies a force to the wafer 200 so that the wafer is aligned with the reference surface 27a, and then the application of the force to the wafer 200 is stopped. This deformation may also be called springback.

For example, a case in which the wafer 200 is warped into a parabolic shape will be described. In this case, it is assumed that the outer periphery 202 is deformed upward with respect to the center 201 due to the reaction force after the application of the force to the wafer 200 is stopped. In this case, when the wafer 200 is deformed to be aligned with the reference surface 27a, the outer periphery 202 is deformed to be positioned downward with respect to the center 201. Then, due to the deformation caused by the reaction force, the wafer 200 becomes a flat plate shape. Note that the shape of the wafer 200 after the application of the force to the wafer 200 is stopped does not have to be a flat plate shape.

The reference member 27 is formed of a metal or the like having a high thermal conductivity. The wafer 200 is mounted on the reference surface 27a. The reference member 27 has a plurality of through holes 27b that penetrate in the vertical direction.

For example, a plurality of through holes 27b include a through hole 27b1 and a plurality of through holes 27b2 (eight in the present embodiment). The through hole 27b1 is formed at a center of the reference member 27. As shown in FIG. **11****,** the plurality of through holes 27b2 are disposed at equal angles around the through hole 27b1 to surround the through hole 27b1 in a plan view.

Note that the number of through holes 27b formed in the reference member 27 and the disposition of the through holes 27b are not limited. The reference member 27 may include a standard for correcting the wafer 200. The standard here has a predetermined shape for making the shape of the wafer 200 closer to a predetermined standard shape, for example.

The heating part 13 is not particularly limited as long as it is a device that heats the wafer 200 mounted on the mounting device 12. In this example, the heating part 13 is a heater. As shown in FIG. 8, for example, the heating part 13 contacts a lower surface of the reference member 27. The heating part 13 indirectly heats the wafer 200 by heating the reference member 27 of the mounting device 12. The heating part 13 does not have to be in contact with the reference member 27.

Note that heating by the heating part may be electromagnetic induction heating, radiation heating, heating by hot air, heating by irradiating with electromagnetic waves or an energy beam, heating by coming into direct or indirect contact with a heat source, or the like.

The force application part 14 applies a force to the wafer 200 mounted on the mounting device 12. As shown in FIGS. 8 and 11, in the present embodiment, the force application part 14 has a plurality of cylindrical members 29, an exhaust part (not shown), and a drive part (which may also be called an actuator or a moving part) 15.

The plurality of cylindrical members 29 are each disposed in the through hole 27b of the reference member 27. For description in more detail, one of the plurality of cylindrical members 29, a cylindrical member 29A, is disposed in the through hole 27b1. A plurality of cylindrical members 29B, which are other than the cylindrical member 29A among the plurality of cylindrical members 29, are each disposed in the plurality of through holes 27b2.

Each cylindrical member 29 can move in a vertical direction (a Z-axis direction) with respect to the reference member 27. In the plan view shown in FIG. 11, the cylindrical member 29A is disposed at a position corresponding to the center of the wafer 200. The plurality of cylindrical members 29B are disposed at equal angles (equal azimuth angles) around the center on a concentric circle with respect to the center of the wafer 200.

The exhaust part exhausts the air in the plurality of cylindrical members 29 to the outside of the plurality of cylindrical members 29. As shown in FIG. 8, an upper end of each cylindrical member 29 functions as a suction part 29a. That is, in this example, the force application part 14 includes a plurality of suction parts 29a. The drive part 15 moves each cylindrical member 29 independently in the vertical direction with respect to the reference member 27.

Note that the number of cylindrical members 29 included in the force application part 14 may be one.

For example, the transport device TR for holding and transporting the wafer 200 has an adsorption part (not shown). For example, an adsorption part of the transport device TR may be a device that vacuum-sucks the wafer 200 from below, a device that sucks the wafer 200 from above using a Bernoulli effect, or the like.

A so-called Bernoulli chuck is preferably used as a device that uses the Bernoulli effect. As is well known, the Bernoulli chuck is a chuck that uses the Bernoulli effect to locally increase a flow rate of a sprayed fluid (for example, air) and sucks (holds without contact) an object. Here, the Bernoulli effect refers to an effect that a pressure of a fluid decreases as the flow rate increases.

In the Bernoulli chuck, a suction state (holding/floating state) is determined by a weight of an object to be sucked (held, fixed) and a flow rate of a fluid sprayed from the chuck. In other words, when a size of the object is known, a dimension of a gap between the chuck and the object to be held during suction is determined according to the flow rate of the fluid sprayed from the chuck.

In this example, the device that uses the Bernoulli effect ejects gas from its gas flow holes (for example, nozzles or ejection ports) to generate a flow of gas (gas flow) around the wafer 200, and sucks the wafer 200.

The transport device TR holds the wafer 200 with a part of the wafer 200 adsorbed by the adsorption part, and transports the wafer 200 from the mounting device 12. The transport device TR may be used to transport the wafer 200 before shape correction to the mounting device 12.

In addition, the transport device TR may also transport the wafer 200 removed from the mounting device 12 and subjected to shape correction to a coating device 36a3, which will be described below.

In this example, the correction apparatus 10 is disposed away from the exposure system 1, but for example, when the correction apparatus 10 is in-line connected to the exposure system 1, the transport device TR may be used to transport the wafer 200 subjected to shape correction to the exposure system 1.

The controller CONT of the correction apparatus 10 has a central processing unit (CPU), a memory, and the like. The memory stores a control program that controls the CPU, a predetermined warpage threshold value, and the like. The memory may store calculation results and determination results by the CPU, measurement results by the measurement part 11, and the like.

The CPU operates on the basis of a control program.

The controller CONT is connected to the measurement part 11, the heating part 13, and the force application part 14, and controls the measurement part 11, the heating part 13, and the force application part 14.

When the controller CONT controls the heating part 13, the controller controls at least one of a position at which the wafer 200 is heated by the heating part 13, a heating time, and an amount of heating. Note that the control by the controller CONT also includes whether to heat the wafer 200.

When the controller CONT controls the force application part 14, the controller CONT controls at least one of the time over which a force is applied to the wafer 200 by the force application part 14, an amount of the force, a position at which the force is applied, and a method of applying the force. Note that the control by the controller CONT also includes whether to apply a force to the wafer 200.

With reference to FIGS. 6 and 7, the exposure system 1 equipped with an exposure apparatus 35 and a coater and developer apparatus 36 will be described. As shown in FIGS. 6 and 7, the coater and developer apparatus 36 includes a coater and developer main body 36a and a transport system (a substrate transport device) 36b.

The coater and developer main body 36a includes a coating table 36a1 and a developing table 36a2.

The coating table 36a1 performs coating processing of a photosensitive material (resist) on the wafer 200 before the exposure processing is performed thereon. The coating table 36a1 is included in the coating device 36a3.

The developing table 36a2 performs developing processing on the wafer 200 after the exposure processing is performed in the exposure apparatus main body 35b which will be described below. The developing table 36a2 is included in a developing device 36a4. The developing device 36a4 develops the wafer 200 exposed by the exposure apparatus 35.

A transport system 36b transports the wafer 200 between the coater and developer main body 36a and the interface section 35a, which will be described below.

Coating processing at the coating table 36a1, development processing at the developing table 36a2, and the transport operation of the transport system 36b are controlled by a control device 36c.

The coater and developer main body 36a (the coating table 36a1 and the developing table 36a2), the transport system 36b, and the like are disposed inside a second chamber device 38 separate from a first chamber device 37, which will be described below. The first chamber device 37 and the second chamber device 38 are connected via an interface section 35a, which will be described below.

The exposure apparatus 35 includes an interface section 35a, an exposure apparatus main body 35b, a transport system 35c, a pre-alignment unit 35d, a temperature regulation unit 35e, and a control device 35f.

The interface section 35a forms a connection part with the coater and developer apparatus 36. The exposure apparatus main body 35b performs exposure processing on the wafer 200 by, for example, an energy beam. The transport system 35c transports the wafer 200.

The interface section 35a, the exposure apparatus main body 35b, and the transport system 35c are disposed inside a first chamber device 37 in which cleanliness is controlled.

The control device 35f centrally controls the operation of the entire exposure apparatus 35.

The interface section 35a may be provided in the coater and developer apparatus 36 instead of the exposure apparatus 35, or may be a device separate from the exposure apparatus 35 and the coater and developer apparatus 36.

As shown in FIG. 6, the interface section 35a is provided with a supply table 35a1 and a recovery table 35a2.

The supply table 35a1 receives the wafer 200 from the coating table 36a1 by the transport system 35c.

The wafer 200 that is subjected to exposure processing by the exposure apparatus main body 35b is mounted on the recovery table 35a2, and the wafer is recovered by the transport system 35c.

As shown in FIG. 7, the exposure apparatus main body 35b includes a mask stage 35b1, a substrate stage 35b2, an illumination optical system 35b3, and a projection optical system 35b4.

The mask stage 35b1 is movable while holding a mask 210. The "mask" includes a reticle on which a device pattern is formed to be reduced and projected onto the wafer 200 coated with a photosensitive material (resist).

The substrate stage 35b2 has a wafer holder 35b5 that holds the wafer 200 coated with a photosensitive material (resist). The substrate stage 35b2 is capable of moving the wafer holder 35b5 which holds the wafer 200.

The illumination optical system 35b3 illuminates the mask 210 held by the mask stage 35b1 with an exposure light EL. The projection optical system 35b4 projects an image of a pattern of the mask 210 illuminated by the exposure light EL onto the wafer 200.

Furthermore, in the present embodiment, a case in which a scanning exposure apparatus (a so-called scanning stepper) is used as the exposure apparatus main body 35b is described as an example. In the scanning exposure apparatus, the exposure apparatus main body 35b synchronously moves the mask 210 and the wafer 200 in different directions (opposite directions) for a scanning direction, and projects the image of the pattern formed on the mask 210 onto the wafer 200.

The exposure apparatus main body 35b is an immersion exposure apparatus that uses an immersion method. The exposure apparatus main body 35b forms an immersion area A3 of liquid LQ on the wafer 200 held on the substrate stage 35b2. The wafer 200 is exposed by irradiating the wafer 200 with the exposure light EL through the liquid LQ in the immersion area A3.

Note that the exposure apparatus main body 35b does not have to be an immersion exposure apparatus, and may be, for example, a dry exposure apparatus that exposes the wafer 200 through a gas between the projection optical system 35b4 and the wafer 200.

As shown in FIGS. 6 and 7, the pre-alignment unit 35d preliminarily (roughly) positions the wafer 200 to be transported to the substrate stage 35b2.

The temperature regulation unit 35e regulates a temperature of the wafer 200 transported to the substrate stage 35b2 to a temperature of the substrate stage 35b2 (an atmospheric temperature of the exposure apparatus main body 35b).

The transport system 35c includes a plurality of transport arms 35c1 to 35c3 (refer to FIG. 7, not shown in FIG. 6) and a plurality of transport arms 35c4 and 35c5 (refer to FIG. 6, not shown in FIG. 7).

The plurality of transport arms 35c1 to 35c3 transport the wafer 200 between the supply table 35a1 in the interface section 35a and the exposure apparatus main body 35b. The plurality of transport arms 35c4 and 35c5 transport the wafer 200 between the recovery table 35a2 and the exposure apparatus main body 35b.

More specifically, the transport system 35c includes a transport arm 35c1, a transport arm 35c2, a transport arm 35c3, a transport arm (unload arm) 35c4, and a transport arm 35c5. An operation of the transport system 35c is controlled by the control device 35f described above.

The transport arm 35c1 transports the wafer 200 from the supply table 35a1 to the pre-alignment unit 35d. The transport arm 35c2 transports the wafer 200 from the pre-alignment unit 35d to the temperature regulation unit 35e.

The transport arm 35c3 carries in the wafer 200 before exposure processing from the temperature regulation unit 35e to the exposure apparatus main body 35b (the substrate stage 35b2). The transport arm 35c4 carries out the wafer 200 after exposure processing from the exposure apparatus main body 35b (the substrate stage 35b2).

The transport arm 35c5 receives the wafer 200 from the transport arm 35c4 and transports it to the recovery table 35a2.

As shown in FIG. 7, the control device 35f has a display device 35f1 that displays a processing status of each component device in the exposure apparatus 35. The processing status of each component device specifically includes a status of exposure processing by the exposure apparatus main body 35b, a transport status of the wafer 200 in the transport system 35c, an alignment status in the pre-alignment unit 35d, a temperature regulation status in the temperature regulation unit 35e, and the like.

Furthermore, the control device 35f and the control device 36c may be connected by, for example, a LAN or the like, and may be able to communicate with each other.

Next, a correction method using the exposure system 1 (the correction apparatus 10) configured as described above will be described.

In the example described below, the wafer 200 that is an object to be exposed by the exposure system 1 is warped into a parabolic shape. The upper ends (the suction parts 29a) of the plurality of cylindrical members 29 of the force application part 14 are disposed flush with the reference surface 27a of the reference member 27 of the mounting device 12 in advance.

First, the controller CONT measures the three-dimensional shape (shape) of the wafer 200 using the measurement part 11. The measurement part 11 also measures the amount of warping of the wafer 200 before it is mounted on the mounting device 12. This shape measuring is performed before performing the shape correction on the wafer 200, which will be described below.

When the amount of warping of the wafer 200 measured by the measurement part 11 is equal to or greater than the warpage threshold value, the controller CONT may cause the force application part 14 to apply a force to the wafer 200 while the heating part 13 heats the wafer 200. In other words, the amount of heating of the wafer 200 and a magnitude of the force applied to the wafer 200 may be adjusted according to the amount of warping of the wafer 200, which is equal to or greater than the warpage threshold value.

Next, the controller CONT causes the heating part 13 to heat the reference member 27 of the mounting device 12 to a predetermined temperature. The wafer 200 is mounted on the reference surface 27a of the reference member 27 of the mounting device 12 by a transfer device (not shown). At this time, the wafer 200 is mounted on the mounting device 12 so that the first surface 203 of the wafer 200 faces downward. The first surface 203 of the wafer 200 comes into contact with the reference surface 27a of the reference member 27 of the mounting device 12. The transport device TR may also be used as a transfer device that mounts the wafer 200 from the measurement part 11 onto the reference member 27 of the mounting device 12.

In this manner, the controller CONT starts heating of the mounting device 12 using the heating part 13 before the wafer 200 comes into contact with the mounting device 12. The controller CONT may start heating of the mounting device 12 using the heating part 13 after the wafer 200 comes into contact with the mounting device 12.

The controller CONT causes the drive part 15 to move the plurality of cylindrical members 29 upward (in the Z1 direction) while using an exhaust part of the force application part 14 to exhaust air from the plurality of cylindrical members 29. When a suction part 29a of the cylindrical member 29 comes into contact with the first surface 203 of the wafer 200, the cylindrical member 29 holds the wafer 200. The controller CONT drives the drive part 15 to move the plurality of cylindrical members 29 downward (in a Z2 direction), and applies a force to the wafer 200. That is, the force application part 14 applies a force to the wafer 200 from the first surface 203 side of the wafer 200 by moving the plurality of cylindrical members 29 downward (in the Z2 direction) while the first surface 203 of the wafer 200 is being attracted to tips of the plurality of cylindrical members 29.

In this manner, the force application part 14 applies a force to the wafer 200 by coming into contact with the wafer 200 mounted on the mounting device 12.

As shown by the two-dot chain line L1 in FIG. 8, the wafer 200 deforms along the reference surface 27a of the reference member 27. The controller CONT causes the force application part 14 to apply a force to the wafer 200 so that the wafer 200 is aligned with the reference surface 27a of the mounting device 12, thereby performing shape correction on the wafer 200.

The plurality of suction parts 29a of the force application part 14 perform the shape correction on the wafer 200 by sucking the wafer 200 from the first surface 203 side of the wafer 200. The suction part of the force application part 14 may perform suction from the second surface 204 side, which is a top surface of the wafer 200.

As described above, the controller CONT performs shape correction on the wafer 200 by applying a force to the wafer 200 using the force application part 14 while heating the wafer 200 using the heating part 13. At this time, the wafer 200 is corrected to an umbrella shape with a smaller amount of warping or deflection compared to before correction, as shown by a two-dot chain line L1. The wafer 200 subjected to shape correction is shown in FIG. 12.

The transport device TR removes the wafer 200 subjected to shape correction from the mounting device 12 and transports it. The wafer 200 subjected to shape correction is carried into the exposure system 1 by a transport device (not shown). For example, the wafer 200 is cooled by outside air or the like, and the corrected shape returns slightly to a flat shape.

In this manner, in this correction method, the amount of warping of the wafer 200 transported from the mounting device 12 by the transport device TR is made smaller by shape correction than the amount of warping of the wafer 200 before the wafer 200 is mounted on the mounting device 12. In other words, the shape correction makes the shape of the wafer 200 transported from the mounting device 12 by the transport device TR closer to a flat shape than the shape of the wafer 200 before the wafer 200 is mounted on the mounting device 12.

The wafer 200 subjected to shape correction may be transported to devices (such as a cleaning device) other than the exposure system 1 (the coater and developer apparatus 36).

A supply request for the wafer 200 is output from the control device 35f of the exposure apparatus 35 to the control device 36c of the coater and developer apparatus 36. The control device 36c then causes the coating device 36a3 to coat the wafer 200 with a photosensitive agent using the coating table 36a1. For example, the photosensitive agent is dried at a temperature between 100°C and 150°C.

The control device 36c causes the transport system 36b to transport the wafer 200 coated with the photosensitive agent to the supply table 35a1 of the interface section 35a. The wafer 200 transported to the supply table 35a1 of the interface section 35a is passed to the pre-alignment unit 35d by the transport arm 35c1. Here, the wafer 200 passed to the pre-alignment unit 35d is roughly aligned (pre-aligned) with respect to the substrate stage 35b2.

The aligned wafer 200 is transported by the transport arm 35c2 to the temperature regulation unit 35e, where its temperature is adjusted to a predetermined temperature that is approximately the same as that of the substrate stage 35b2. The wafer 200 is then carried onto the substrate stage 35b2 of the exposure apparatus main body 35b by the transport arm 35c3. Then, the wafer 200 subjected to exposure processing is carried out from the substrate stage 35b2 by the transport arm 35c4 and then handed over to the transport arm 35c5. The wafer 200 is transported to the recovery table 35a2 by the transport arm 35c5.

The wafer 200 is mounted on the recovery table 35a2 and makes it possible to recover a substrate. At this time, the control device 35f outputs a substrate recovery request to the control device 36c of the coater and developer apparatus 36. When the substrate recovery request is notified, the control device 36c causes the transport system 36b to recover the wafer 200 mounted on the recovery table 35a2 and to transport it to the developing table 36a2.

In this manner, the wafer 200 is transported by the transport systems 36b and 35c, and undergoes a series of processes including photosensitive coating processing, exposure processing, and development processing.

In this manner, in the correction method of the present embodiment, a force is applied to the wafer 200 while the wafer 200 is heated, and shape correction is performed on the wafer 200. Then, the wafer 200 subjected to shape correction is transported.

As described above, in the correction apparatus 10 and the correction method of the present embodiment, the wafer 200 is mounted by the mounting device 12. A force is applied to the wafer 200 while the wafer 200 is heated, and shape correction is performed on the wafer 200. Then, the wafer 200 subjected to shape correction is transported.

As described above, by applying a force to the wafer 200 whose rigidity has been reduced by heating, it is possible to reliably perform correction on the wafer 200. Then, the wafer 200 that is subjected to shape correction and has been removed from the mounting device 12 can be transported.

Shape correction makes the amount of warping of the wafer 200 transported from the mounting device 12 by the transport device TR smaller than the amount of warping of the wafer 200 before the wafer is mounted on the mounting device 12. This allows subsequent processing of the wafer 200 to be performed with a small amount of warping or deflection. In addition, the wafer 200 with a small amount of warping or deflection can be carried into a device that will subsequently perform the processing of the wafer 200.

Shape correction makes the shape of the wafer 200 transported by the transport device TR closer to a flat shape than the shape of the wafer 200 before the wafer is mounted on the mounting device 12. This allows the subsequent processing of the wafer 200 to be performed with its shape corrected to a flat shape. Furthermore, the wafer 200 whose shape has been corrected to a flat shape can then be carried into a device that will subsequently perform the processing of the wafer 200.

The transport device TR may transport the wafer 200 subjected to shape correction to the exposure system 1. This allows the exposure system 1 to perform processing on the wafer 200 while the wafer is subjected to the shape correction.

The controller CONT causes the force application part 14 to apply a force to the wafer 200 so that the wafer 200 is aligned with the reference surface 27a of the mounting device 12, thereby performing the shape correction on the wafer 200. By applying a force so that the wafer 200 is aligned with the reference surface 27a, it is possible to reliably perform the shape correction on the wafer 200.

The controller CONT controls the force application part 14 so that a force is applied to the wafer 200 to make the wafer 200 aligned with the reference surface 27a. In this manner, shape correction of the wafer 200 is performed. This makes it possible to stabilize the corrected shape of the wafer 200 to the shape of the reference surface 27a.

The heating part 13 heats the mounting device 12 (the reference member 27), thereby heating the wafer 200. The heating part 13 indirectly heats the wafer 200 via the mounting device 12 (the reference member 27), and thereby it is possible to prevent a temperature of the wafer 200 from rising abruptly.

The controller CONT starts heating of the mounting device 12 using the heating part 13 before the wafer 200 comes into contact with the mounting device 12. By heating the mounting device 12 before the wafer 200 comes into contact with the mounting device 12, the wafer 200 can be heated quickly via the mounting device 12.

The first surface 203 of the wafer 200 comes into contact with the reference surface 27a of the mounting device 12, and the force application part 14 applies a force to the wafer 200 from the first surface 203 side of the wafer 200. Since the second surface 204 of the wafer 200 is a process surface, it is possible to prevent the second surface 204 from being damaged due to a force being applied to the second surface 204.

The force application part 14 may also apply a force to the wafer 200 from the second surface 204 side, which is the top surface of the wafer 200. In this case, a force can be applied to the wafer 200 from the widely open second surface 204 side of the wafer 200 that is not in contact with the reference surface 27a of the mounting device 12.

The plurality of suction parts 29a perform shape correction on the wafer 200 by sucking the wafer 200 from the first surface 203 side, which is the bottom surface of the wafer 200. Since gravity acts downward on the wafer 200, suction of the wafer 200 can be performed more easily than when suction is performed from the second surface 204 side, which is the top surface of the wafer 200.

The controller CONT measures the shape of the wafer 200 using the measurement part **11** before shape correction is performed on the wafer 200. This makes it possible to check a state of the wafer 200, such as the amount of warping, before the shape correction is performed, and to easily determine whether the shape correction of the wafer 200 is necessary.

When the amount of warping of the wafer 200 measured by the measurement part **11** is equal to or greater than the warpage threshold value, the controller CONT may cause the force application part 14 to apply a force to the wafer 200 while the heating part 13 heats the wafer 200. In this case, the amount of heating of the wafer 200 and the magnitude of the force applied to the wafer 200 can be adjusted according to the amount of warping of the wafer 200 that is equal to or greater than the warpage threshold value.

The shape of the reference surface 27a of the mounting device 12 is a shape of a convex part. The warpage of the wafer 200 can be corrected by using the reference surface 27a in a smooth shape.

The shape of the reference surface 27a of the mounting device 12 is designed on the basis of the deformation caused by a reaction force after the force application part 14 applies a force to the wafer 200 so that the wafer 200 is aligned with the reference surface 27a and then the application of the force to the wafer 200 is stopped. For this reason, by taking into account the deformation caused by the reaction force, the shape of the wafer 200 subjected to correction can be made even closer to a flat shape.

The controller CONT controls at least one of a time over which a force is applied to the wafer 200, an amount of the force applied to the wafer 200, a position at which the force is applied to the wafer 200, and a method of applying the force to the wafer 200 by the force application part 14. For this reason, the force applied to the wafer 200 by the force application part 14 can be accurately controlled in accordance with the warpage of each wafer 200.

The controller CONT controls at least one of a position at which the wafer 200 is heated, a heating time, and an amount of heating by the heating part 13. For this reason, the heating of the wafer 200 by the heating part 13 can be accurately controlled in accordance with the warpage of each wafer 200.

The force application part 14 applies a force to the wafer 200 by coming into contact with the wafer 200 mounted on the mounting device 12. Therefore, it is possible to reliably apply a force for correction to the wafer 200 stably mounted by the mounting device 12.

The wafer 200 has a smaller dimension in a cross direction than a dimensions along the first orthogonal direction D1 and the second orthogonal direction D2.

In addition, in the exposure system 1 of the present embodiment, the exposure system 1 can be configured using a correction apparatus 10 that can reliably perform the correction of the wafer 200.

The correction apparatus 10 does not need to include the measurement part 11. In addition, the correction apparatus 10 does not need to include the transport device TR. In this case, transport of the wafer 200, on which the shape correction has been performed, from the mounting device 12 may be performed using a transport device that is not a part of the correction apparatus 10.

The correction apparatus 10 and the correction method of the present embodiment can be modified in various ways as described below.

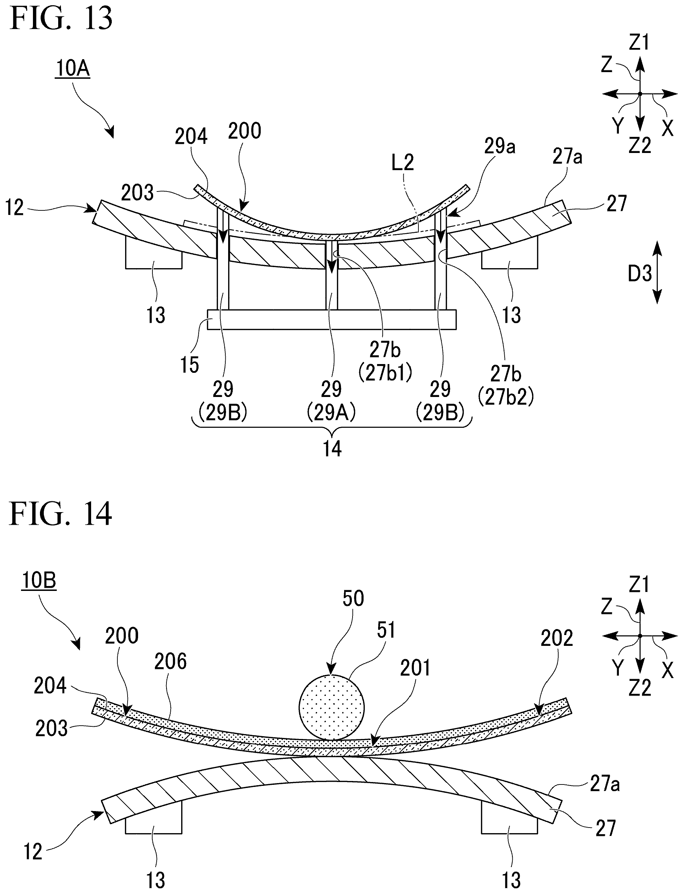

As in the correction apparatus 10A of the first modified example shown in FIG 13, the reference surface 27a of the reference member 27 of the mounting device 12 may be curved so as to be convex downward over an entire circumference of the reference surface 27a. In other words, the shape of the reference surface 27a of the mounting device 12 may be a concave shape.

Even in this case, the wafer 200 can be corrected as shown by the two-dot chain line L2. The warpage of the wafer 200 can be corrected with the reference surface 27a having a smooth shape.

The correction apparatus 10 may include a plurality of reference members 27 with different shapes of the reference surface 27a, and the reference members 27 may be replaced according to a desired correction shape.

Moreover, in the mounting device 12 shown in FIGS. 8, 11, and 13, the wafer 200 before shape correction is mounted on the reference member 27, but it may be mounted on the plurality of cylindrical members 29. The cylindrical members 29 are raised, and the wafer 200 before shape correction is mounted on the plurality of cylindrical members 29 with each suction part of the cylindrical members 29 disposed at a position separated away from the reference surface 27a. Then, the plurality of cylindrical members 29 are lowered while each cylindrical member 29 is holding the wafer 200 by suction, thereby correcting the shape of the wafer 200 on the reference member 27. In this case, positions of each suction part of the cylindrical members 29 in the Z-axis direction when the wafer 200 is mounted may be controlled on the basis of a result of measurement by the measurement part 11.

The correction apparatus of the second modified example may include a cooling part CO (refer to FIG. 6) for cooling the wafer 200 on which shape correction has been performed. For example, the cooling part CO cools the wafer 200 using cooling water, a Peltier element, or the like. The cooling part CO may be disposed between the mounting device 12 and the coating device 36a3, and the wafer 200 may be cooled when the wafer 200 is transported between the mounting device 12 and the coating device 36a3.

In the correction apparatus of the second modified example, the shape of the wafer 200 subjected to correction can be quickly stabilized while being heated by the heating part 13.

As shown in FIG. 8, in a correction apparatus of a third modified example, the cooling part 45 may be disposed so as to come into contact with a lower surface of the reference member 27. In this case, the cooling part 45 cools the wafer 200 subjected to shape correction while the wafer 200 is mounted on the mounting device 12.

In this third modified example, while the wafer 200 is mounted on the mounting device 12, the shape of the wafer 200 subjected to correction can be stabilized while being heated by the heating part 13.

The controller CONT may measure the shape of the wafer 200 using the measurement part 11 after the mounting device 12, the heating part 13, and the force application part 14 have performed shape correction on the wafer 200. By performing such a process, the amount of warping of the wafer 200 can be detected after shape correction.

A correction apparatus 10B of a fourth modified example shown in FIG. 14 includes a mounting device 12, a heating part 13, and a force application part 50. A protective layer 206 is provided on the second surface 204 of the wafer 200 used in the correction apparatus 10B of the fourth modified example. The protective layer 206 is composed of a protective tape, a coating layer, or the like. The protective layer 206 is removable from the second surface 204 of the wafer 200. It is preferable that the protective layer 206 have a heat resistance of 50°C or more and 300°C or less.

The heating part 13 may be disposed away from the reference member 27. The heating part 13 may heat the wafer 200 mounted on the reference member 27 of the mounting device 12 by radiant heat or the like.

For example, the force application part 50 has a roller 51. The roller 51 comes into contact with a top surface of the protective layer 206 from above the protective layer 206, thereby applying a force to the wafer 200 mounted on the mounting device 12.

After the correction of the wafer 200 is completed, the protective layer 206 is removed from the wafer 200.

In the correction apparatus 10B of the fourth modified example, the correction of the wafer 200 can be reliably performed by applying a force to the wafer 200 whose rigidity has been reduced by heating.

In the correction apparatus 10B of the fourth modified example, the force application part may apply a force to the wafer 200 mounted on the mounting device 12 by gripping the outer periphery 202 of the wafer 200 and bending the wafer 200.

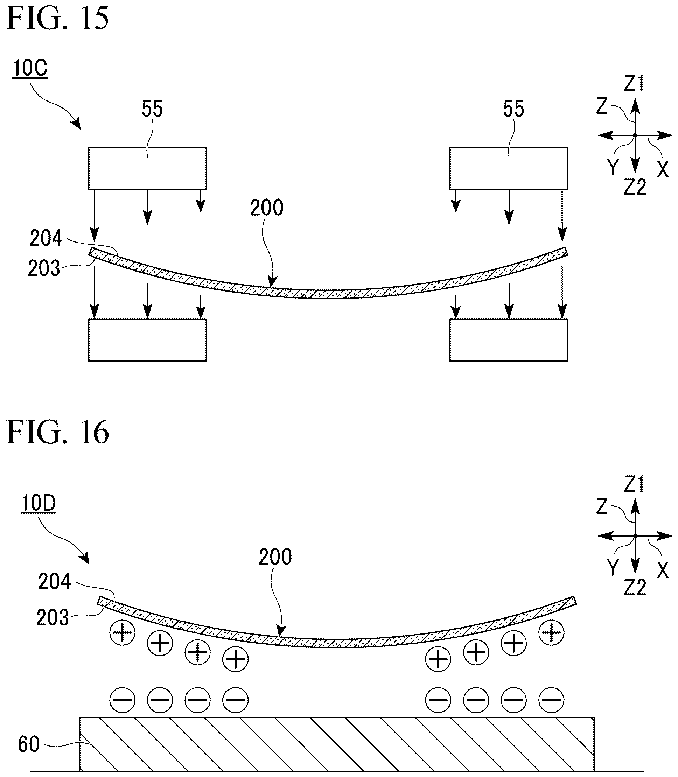

A correction apparatus 10C of a fifth modified example shown in FIG. 15 includes a force application part 55 instead of the force application part 50 of the correction apparatus 10B of the fourth modified example. Note that the mounting device 12 is not shown in FIG. 15.

For example, the force application part 55 performs vacuum suction from the first surface 203 and the second surface 204. It is preferable that the force application part 55 be able to arbitrarily change a distribution of the force applied to the wafer 200. The force application part 55 corrects the wafer 200 by applying a force to the wafer 200 mounted on the mounting device 12.

A correction apparatus 10D of a sixth modified example shown in FIG. 16 includes a force application part 60 instead of the mounting device 12 and the force application part 50 of the correction apparatus 10B of the fourth modified example. The force application part 60 serves as both a mounting device and a force application part. In the correction apparatus 10D of the sixth modified example, the force application part 60 is provided on the first surface 203 side (below) of the wafer 200. The force application part 60 mounts the wafer 200 thereon, and applies a force to the mounted wafer 200 by an electrical force, known as an electrostatic chuck.

In this case, the correction apparatus 10D may be disposed in a vacuum chamber. The force application part 60 may also be provided on the second surface 204 side (upper) of the wafer 200.

In the present invention, being mounted on a mounting device does not only mean that the wafer 200 is supported in contact with the mounting device, but also means that the wafer 200 is separated from the mounting device and is held by the mounting device in a state where it is suspended in the air. A force that holds the wafer 200 in the air is not limited to an electrical force. The force that holds the wafer 200 in the air may be a magnetic force, a force due to the Bernoulli effect, or the like.

In addition, the force application part may apply a force to the wafer 200 by an electrical force, a magnetic force, or the like without coming into contact with the wafer 200 when the wafer 200 is mounted on the mounting device 12 as described above. With this configuration, the wafer 200 can be corrected while suppressing the effect on the wafer 200 without coming into contact with the second surface 204, which is a process surface of the wafer 200, or the like.

In a correction apparatus of a seventh modified example, the shape of the wafer 200 may be corrected by the force application part applying a force to the wafer 200 so that the wafer is aligned with the mounting device 12 while the heating part heats the wafer 200.

In a correction method corresponding to the correction apparatus of the seventh modified example configured as described above, the shape of the wafer 200 is corrected by applying a force to the wafer 200 so that the wafer 200 is aligned with the mounting device 12 while heating the wafer 200.

In the correction apparatus of the seventh modified example configured as described above and the corresponding correction method, the correction of the wafer 200 can be reliably performed by applying a force to the wafer 200 whose rigidity has been reduced by heating.

A correction apparatus of an eighth modified example includes a reference member 27 instead of the mounting device 12 of the correction apparatus of the seventh modified example. In this case, the force application part applies a force to the wafer 200 so that the wafer 200 is aligned with the reference surface 27a of the reference member 27, thereby applying a force to the wafer 200.

In a correction method corresponding to the correction apparatus of the eighth modified example configured as described above, a force is applied to the wafer 200 so that the wafer 200 is aligned with the reference surface 27a while the wafer 200 is heated, thereby applying a force to the wafer 200.

The correction apparatus of the eighth modified example and the corresponding correction method can reliably correct the wafer 200 by applying a force to the wafer 200 whose rigidity has been reduced by heating so that the wafer 200 is aligned with the reference surface 27a.

A correction apparatus of a ninth modified example may include a holding part and a force application part (not shown) instead of the mounting device 12, the force application part 14, and the transport device TR in the correction apparatus 10 of the present embodiment.

The holding part holds the center 201 of the wafer 200.

For example, the force application part holds the outer periphery 202 of the wafer 200. The force application part applies a force to the outer periphery 202 of the wafer 200 in the thickness direction D3.

The controller causes the force application part to apply a force to the outer periphery 202 of the wafer 200 on the basis of the three-dimensional shape measured by the measurement part 11 while the heating part 13 heats the wafer 200, thereby deforming the wafer 200.

In a correction method corresponding to the correction apparatus of the ninth modified example configured as described above, while heating the wafer 200, a force is applied to the outer periphery 202 of the wafer 200 in the thickness direction D3 on the basis of the three-dimensional shape of the wafer 200. The wafer 200 is then deformed.

In the correction apparatus of the ninth modified example and the corresponding correction method, a force is applied to the outer periphery 202 of the wafer 200 in the thickness direction D3 on the basis of the three-dimensional shape of the wafer 200, so that the wafer 200 can be deformed and corrected.

A correction apparatus of a tenth modified example may include a holding part and a force application part described below instead of the holding part and the force application part in the correction apparatus of the ninth modified example.

The holding part holds a first portion of the wafer 200. For example, the first portion is the center of the wafer 200. The force application part applies a force that deforms a second portion of the wafer 200 that is outside the first portion in the thickness direction D3.

The controller causes the force application part to apply a force to the wafer 200 by applying a force to the second portion of the wafer 200 on the basis of the three-dimensional shape measured by the measurement part 11 while the heating part 13 heats the wafer 200.

In a correction method corresponding to the correction apparatus of the tenth modified example configured as described above, the first portion of the wafer 200 is held. Then, a force is applied to the wafer 200 by applying the force to the second portion of the wafer 200 on the basis of the three-dimensional shape of the wafer 200 while heating the wafer 200.

In the correction apparatus of the tenth modified example and the corresponding correction method, a first portion of the wafer 200 is held. In this state, a force is applied to a second portion that is outside the first portion on the basis of the three-dimensional shape of the wafer 200, and the wafer 200 can be deformed and corrected.

In the correction apparatus of the embodiment and the modified examples described above, the controller may cause the measurement part 11 to measure the shape of the wafer 200 before applying a force to the wafer 200.

This makes it possible to check the state of the wafer 200, such as the amount of warping, before applying a force to the wafer 200, and to easily determine whether the shape correction of the wafer 200 is necessary or not.

In the correction apparatus of the embodiment and modified examples described above, the controller may measure the shape of the wafer 200 using the measurement part 11 after deforming the wafer 200. When the amount of warping of the wafer 200 measured by the measurement part 11 is equal to or greater than the warpage threshold value, the force application part may apply a force to the wafer 200 while the heating part 13 heats the wafer 200.

In this case, the amount of heating of the wafer 200 and the magnitude of the force applied to the wafer 200 can be adjusted according to the amount of warping of the wafer 200 that is equal to or greater than the warpage threshold value.

In the correction apparatus of the embodiment and modified examples described above, a cooling part for cooling the corrected wafer 200 may be provided. With this configuration, the shape of the wafer 200 that has been corrected while being heated by the heating part 13 can be quickly stabilized.

A correction apparatus of an eleventh modified example does not need to include the measurement part 11 and the controller in the ninth modified example of the present embodiment. In this correction apparatus of the eleventh modified example, the force application part applies a force to the wafer 200 by applying the force to the outer periphery 202 of the wafer 200 in the thickness direction D3.

In a correction method corresponding to the correction apparatus of the eleventh modified example configured as described above, firstly, the center 201 of the wafer 200 is held. Next, while heating the wafer 200, a force is applied to the wafer 200 by applying the force to the outer periphery 202 of the wafer 200 in the thickness direction D3.

In the correction apparatus of the eleventh modified example and the corresponding correction method configured as described above, a force is applied to the outer periphery 202 of the wafer 200 in the thickness direction D3. Then, by applying the force to the wafer 200, the wafer 200 can be corrected.

A correction apparatus of a twelfth modified example may include a force application part, which will be described below, instead of the mounting device 12, the force application part 14, and the transport device TR in the correction apparatus 10 of the present embodiment.

The force application part applies a force to the wafer 200 by applying the force to the wafer 200.

While the heating part 13 heats the wafer 200, the controller CONT performs control of causing the force application part 14 to apply different forces at different positions on the surface of the wafer 200 (the surfaces 203 and 204) on the basis of the shape of the wafer 200 measured by measurement part 11.

In a correction method corresponding to the correction apparatus of the twelfth modified example configured as described above, first, the shape of the wafer 200 is measured. Next, while heating the wafer 200, different forces are applied at different positions on the surface of the wafer 200 on the basis of the shape of the wafer 200.

In the correction apparatus of the twelfth modified example and the corresponding correction method, the force applied at different positions on the surface of the wafer 200 can be adjusted on the basis of the shape of the wafer 200.

In the correction apparatus of the twelfth modified example, the controller CONT may perform control of causing the force application part to apply forces with different pushing amounts at different positions on the surface of the wafer 200 on the basis of the shape of the wafer 200 measured by the measurement part 11 while the heating part 13 heats the wafer 200.

In this case, in the corresponding correction method, forces with different pushing amounts are applied at different positions on the surface of the wafer 200 on the basis of the shape of the wafer 200 while heating the wafer 200 after measuring the shape of the wafer 200.

Even in this case, the same effects as those of the correction apparatus of the twelfth modified example and the corresponding correction method can be achieved.

As described above, the exposure apparatus 35 includes a transport system 35c as a transport device. In this case, it is preferable that the correction apparatus correct the shape of the wafer 200 so that the transport system 35c can transport the wafer 200. With this configuration, it is possible to prevent the wafer 200 from falling or shifting in position when the wafer 200 subjected to shape correction is transported by the transport system 35c of the exposure apparatus 35.

As described above, the coater and developer apparatus 36 includes the transport system 36b as a transport device. In this case, it is preferable that the correction apparatus correct the shape of the wafer 200 so that the transport system 36b can transport the wafer 200. With this configuration, it is possible to prevent the wafer 200 from falling or shifting in position when the wafer 200 subjected to shape correction is transported by the transport system 36b.

### (Second embodiment)

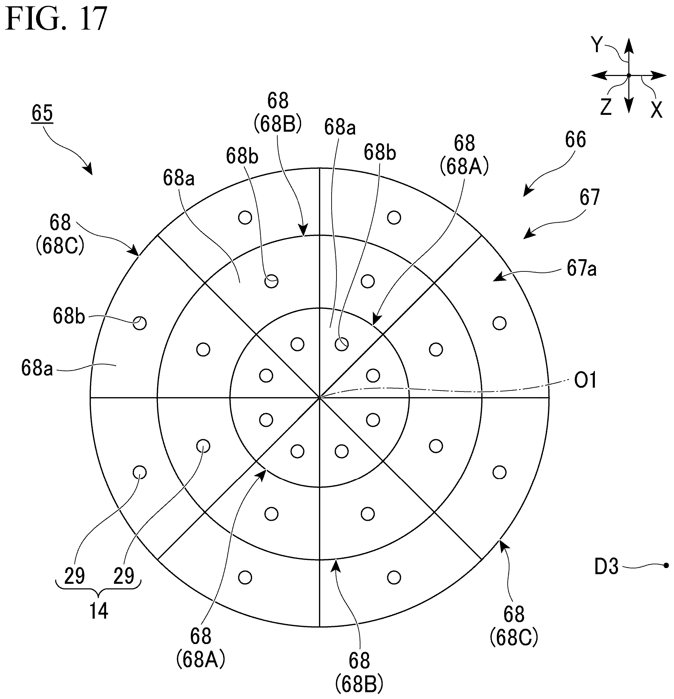

Next, a second embodiment of the present invention will be descried with reference to FIG. 17. The same reference numerals will be denoted for the same parts as in the embodiment described above, and the description thereof will be omitted. Only differences will be described.

As shown in FIG. 17, the correction apparatus 65 of the present embodiment includes a mounting device 66 and a drive part (moving part) 15 (not shown in FIG. 17) instead of the mounting device 12 in the correction apparatus 10 of the first embodiment.

The reference member 67 included in the mounting device 66 has a reference surface 67a, which is a top surface of the reference member 67 used for the correction of the wafer 200. The reference member 67 includes a plurality of divided reference members 68. The plurality of divided reference members 68 (reference members 67) are disc-shaped as a whole.

In the present embodiment, the reference member 67 is divided into a plurality of parts in the circumferential direction and a plurality of parts in the radial direction. To describe in more detail, for example, the plurality of divided reference members 68 include a plurality of divided reference members 68A, a plurality of divided reference members 68B, and a plurality of divided reference members 68C.

The plurality of (eight in the present embodiment) divided reference members 68A are disposed at equal angles around a reference line O1 along the vertical direction. The plurality of divided reference members 68A are disposed near the reference line O1.

The plurality of (eight in the present embodiment) divided reference members 68B surround the plurality of divided reference members 68A from a radial outside of the reference member 67. Each divided reference member 68B is disposed radially outside the divided reference member 68A.

The plurality of (eight in the present embodiment) divided reference members 68C surround the plurality of divided reference members 68B from the radial outside of the reference member 67. Each divided reference member 68C is disposed radially outside the divided reference member 68B.

The top surface of each divided reference member 68 is a divided correction surface 68a. In other words, the reference member 67 has a plurality of divided correction surfaces 68a that form the reference surface 67a.

Each divided reference member 68 has a through hole 68b that penetrates in the vertical direction. To explain in more detail, in the present embodiment, eight through holes 68b are formed in each of the plurality of divided reference members 68A, the plurality of divided reference members 68B, and the plurality of divided reference members 68C. A total of 24 through holes 68b are formed in the plurality of divided reference members 68.

The number of divided reference members 68 included in the reference member 67 and the arrangement of the through holes 68b formed in the divided reference members 68 are not limited.

Each cylindrical member 29 of the force application part 14 is disposed in the through hole 68b of each divided reference member 68. Each cylindrical member 29 of the force application part 14 is provided for each divided correction surface 68a of the plurality of divided reference members 68.

For example, the drive part 15 has a gear set and a motor connected to each divided reference member 68. When the motor is driven, the gear set operates to move the divided reference members 68 in the vertical direction. The drive part 15 moves the plurality of divided reference members 68 independently from each other in the thickness direction D3.

The correction apparatus 65 of the present embodiment configured as described above can reliably correct the wafer 200 by applying a force to the wafer 200 whose rigidity has been reduced by heating.

Furthermore, the reference member 67 includes the plurality of divided reference members 68, and the drive part 15 moves the plurality of divided reference members 68 independently from each other in the thickness direction D3. As a result, the reference surface 67a, which is composed of the plurality of divided correction surfaces 68a, can be deformed into a desired shape according to the warpage shape of the wafer 200.

### (Third embodiment)

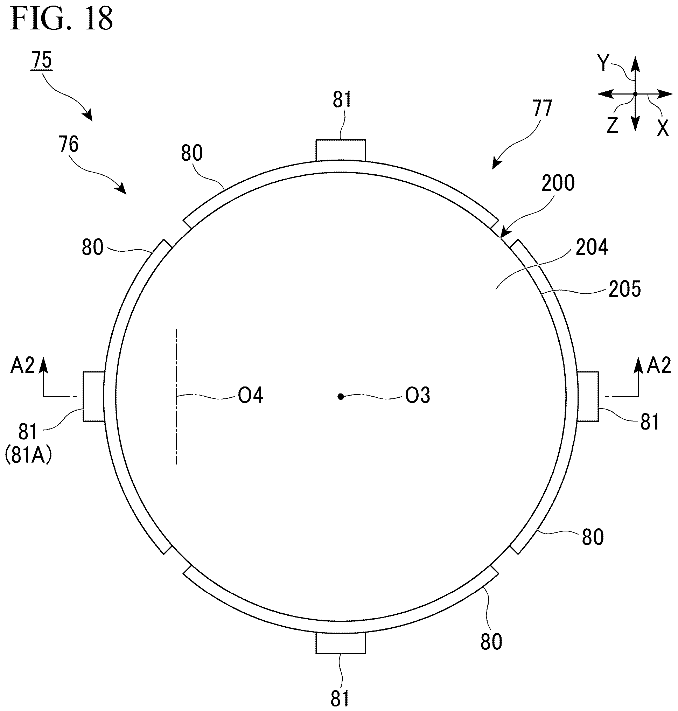

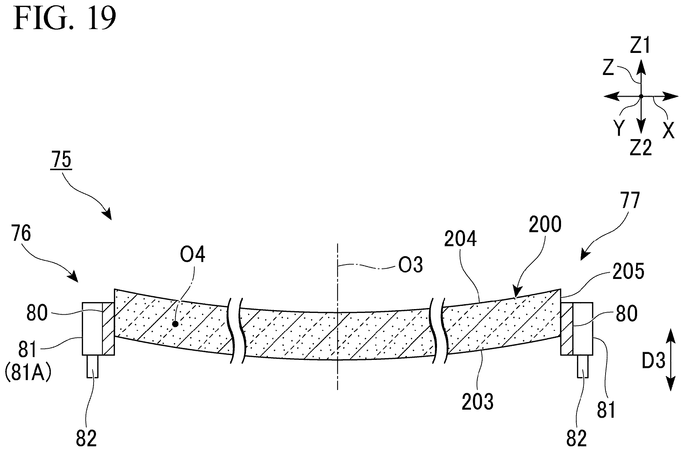

Next, a third embodiment of the present invention will be described with reference to FIGS. 18 and 19, but the same parts as those in the previous embodiment are given the same reference numerals and their description will be omitted, and only the differences will be described.

As shown in FIGS. 18 and 19, the correction apparatus 75 of the present embodiment includes a holding part 76, a heating part 82, and a force application part 77.

The holding part 76 has a plurality of holding pieces 80. Each holding piece 80 is arc-shaped. The plurality of holding pieces 80 hold a side surface 205 of the wafer 200 while being divided in the circumferential direction of the wafer 200 without coming into contact with the second surface 204 of the wafer 200. The side surface 205 is a side surface of the wafer 200 in the thickness direction D3. Each holding piece 80 is attachable to and detachable from the side surface 205 of the wafer 200.

The heating part 82 heats the wafer 200. The heating part 82 is attached to a plurality of holding pieces 80 and heats the wafer 200 via the holding pieces 80. The heating part 82 may be disposed away from the holding pieces 80, or the wafer 200 may be heated directly.

The force application part 77 has a plurality of force application pieces 81. For example, each force application piece 81 is fixed to an outer surface of each holding piece 80. Each force application piece 81 has a bending moment applied to the wafer 200 via each holding piece 80. Here, a central axis of the plurality of holding pieces 80 (wafer 200) is defined as O3. Among the plurality of force application pieces 81, the force application piece 81 of interest is referred to as a force application piece 81A.

In a plan view, a second reference line O4 that is orthogonal to a line connecting the force application piece 81A and the central axis O3 is defined. The force application piece 81A has a bending moment applied to around the second reference line O4. An axis for bending the bending moment applied by the force application piece 81A varies depending on the force application piece 81 of interest.

The force application part 77 applies a force to the wafer 200 via the holding part 76. The force application part 77 deforms the first surface 203 and the second surface 204 of the wafer 200. The plurality of force application pieces 81 of the force application part 77 bend the wafer 200 so that it is convex upward or downward.

In the correction method corresponding to the correction apparatus 75 of the present embodiment configured as described above, first, the side surface 205 of the wafer 200 is held by the holding part 76. Next, while heating the wafer 200, a force is applied to the wafer 200 via the holding part 76 to deform the wafer 200.

With the correction apparatus 75 and the correction method of the present embodiment configured as described above, it is possible to reliably perform the correction on the wafer 200 by applying a force to the wafer 200 whose rigidity has been reduced by heating.

Furthermore, the wafer 200 can be corrected while holding the side surface 205 of the wafer 200, which has a relatively small effect on the wafer 200.

The holding part 76 has a plurality of holding pieces 80, and each force application piece 81 has a bending moment applied to the wafer 200 via each holding piece 80. Therefore, the bending moment applied to a desired portion of the wafer 200 in the circumferential direction can be individually adjusted.

The holding part 76 may be integrally configured without being divided into a plurality of holding pieces 80.

The correction apparatus 75 and the correction method of the present embodiment may be modified in various ways as described below.

The correction apparatus 75 of the first modified example may include the measurement part 11 and the controller CONT in addition to the components of the correction apparatus 75 of the present embodiment. The controller CONT causes the heating part 82 to heat the wafer 200. While heating, the controller CONT applies a force to the wafer 200 by causing the force application part 77 to apply a force to the wafer 200 via the holding part 76 on the basis of the shape measured by the measurement part 11.

With the correction apparatus 75 of the first modified example configured as described above, the wafer 200 can be corrected on the basis of the shape measured by the measurement part 11.

After correcting the wafer 200, the controller CONT may cause the measurement part 11 to measure the shape of the wafer 200. When the amount of warping of the wafer 200 measured by the measurement part 11 is equal to or greater than the warpage threshold value, the force application part 77 may apply a force to the wafer 200 via the holding part 76 while the heating part 82 heats the wafer 200.

In this case, the amount of heating of the wafer 200 and the magnitude of the force applied to the wafer 200 can be adjusted according to the amount of warping of the wafer 200 that is equal to or greater than the warpage threshold value.

The correction apparatus 75 may include a cooling part that cools the deformed wafer 200.

With such a configuration, the shape of the wafer 200 that has been deformed (corrected) while being heated by the heating part can be quickly stabilized.

In the correction apparatus 75 of the second modified example, instead of the force application part 77 of the correction apparatus 75 of the present embodiment, a force application part that applies a force to the wafer 200 by directly applying the force to the wafer 200 may be provided. That is, the correction apparatus 75 of the second modified example includes the holding part 76, the heating part 82, and the force application part of this second modified example. As the force application part, the force application part 14, the force application part 55, or the like can be used.

In the correction method corresponding to the correction apparatus 75 of the second modified example configured as described above, firstly, the side surface 205 of the wafer 200 is held. Next, the wafer 200 is heated and a force is applied directly to the wafer 200 to apply a force to the wafer 200.

In the second modified example of the correction apparatus 75 configured as described above and the corresponding correction method, the wafer 200 can be reliably corrected by applying a force to the wafer 200 whose rigidity has been reduced by heating with the heating part 82.

Furthermore, the wafer 200 can be corrected while holding the side surface 205 of the wafer 200, which has a relatively small effect on the wafer 200.

In the first to third embodiments and each modified example described above, a force is applied to the wafer 200 while a heating part (13, or the like) heats the wafer 200 before shape correction, but the heating part may be omitted. In other words, the shape of the wafer 200 may be corrected by applying a force to the wafer 200 using a force application part (14, or the like) without heating the wafer 200.

In the first to third embodiments and each modified example described above, the correction apparatus (10, or the like) may be included in the exposure apparatus 35. In this case, the transport system 35c of the exposure apparatus 35 may be used to transport the wafer 200 on which shape correction has been performed.

In the first to third embodiments and each modified example described above, the correction apparatus (10, or the like) may be included in the coater and developer apparatus 36. In this case, the transport system 36b of the coater and developer apparatus 36 may be used to transport the wafer 200 subjected to shape correction.

Although the first to third embodiments have been described above in detail with reference to the drawings, the specific configurations are not limited to these embodiments, and modifications, combinations, deletions, and the like of the configurations may be made within a range not departing from the scope of the present invention. Furthermore, it goes without saying that the configurations shown in each embodiment can be used in appropriate combinations.

For example, in the first to third embodiments, the exposure method may be an exposure method of exposing the wafer 200 to an energy beam. In this case, the exposure method may include exposing the wafer 200, whose shape has been corrected by the correction apparatus, using the energy beam.

By performing the process and using a correction apparatus that can reliably perform the shape correction on the wafer 200, an accuracy of an irradiation position of the energy beam can be increased in the exposure method.

In addition, the device manufacturing method using the exposure system may include the following processes. That is, the device manufacturing method includes an exposure step. This exposure step includes developing the wafer 200 exposed using the exposure system.

By carrying out the steps, the wafer 200 can be accurately exposed using an exposure system that can reliably perform the correction on the wafer 200. Then, the wafer 200 can be developed.

The shape of the reference surface 27a of the mounting device 12 may be a shape other than a shape of a concave or a convex part. For example, the shape of the reference surface may be a saddle shape, or the like.

The shape of the reference surface 27a of the mounting device 12 may be designed without being based on the deformation due to the reaction force.

The controller CONT does not need to control a position at which the heating part 13 heats the wafer 200, a heating time, and an amount of heating. The controller CONT does not need to control a time over which the force application part 14 applies a force to the wafer 200, an amount of the force, a position at which the force is applied, and a method of applying the force.

Although an example has been shown in which the three-dimensional shape of the wafer 200 is measured by the measurement part 11, the shape of the wafer 200 measured by the measurement part 11 may be a two-dimensional shape of the wafer 200, or the like.

In the description above, the second surface of the wafer 200 is a process surface on which various elements and the like are formed, but the first surface 203 of the wafer 200 may be the process surface, or both the first surface 203 and the second surface 204 of the wafer 200 may be process surfaces.

The present specification also discloses the inventions described below.

### (Supplementary claim 1)

A correction method includes performing shape correction of a wafer by applying a force to the wafer while the wafer is heated, and transporting the wafer subjected to the shape correction.

### (Supplementary claim 2)

The correction method includes correcting a shape of a wafer by applying a force to the wafer so that the wafer is aligned with a mounting device, while the wafer is heated.

### (Supplementary claim 3)

The correction method includes applying a force to a wafer by applying the force so that the wafer is aligned with a reference surface, while the wafer is heated.

### (Supplementary claim 4)

The correction method includes deforming a wafer by applying a force to an outer periphery of the wafer in a first direction on the basis of a three-dimensional shape of the wafer while the wafer is heated.

### (Supplementary claim 5)

The correction method includes holding a first portion of a wafer, and applying a force to the wafer by applying the force to a second portion of the wafer that is outside the first portion on the basis of the three-dimensional shape of the wafer, while the wafer is heated.

### (Supplementary claim 6)

The correction method includes holding a center of a wafer, and applying a force to the wafer by applying the force to an outer periphery of the wafer in a first direction of the wafer while the wafer is heated.

### (Supplementary claim 7)

The correction method includes holding, by a holding part, a side surface of a wafer, and deforming the wafer by applying a force to the wafer via the holding part while the wafer is heated.

### (Supplementary claim 8)

The correction method includes holding a side surface of a wafer in a first direction, heating the wafer, and applying a force to the wafer to apply a force to the wafer.

### (Supplementary claim 9)

The correction method includes measuring a shape of a wafer, and applying different forces at different positions on a surface of the wafer or applying forces with different pushing amounts at different positions on the surface of the wafer on the basis of the shape of the wafer while the wafer is heated.

### [Industrial Applicability]

According to the present invention, a correction apparatus capable of reliably correcting a wafer can be provided, and accordingly, the industrial applicability is great.

### [Reference Signs List]

1 Exposure system
10, 10A,10B, 10C, 10D, 65, 75 Correction apparatus
11 Measurement part
12, 66 Mounting device
13 Heating part
14, 50, 55, 77 Force application part
27, 67 Reference member
27a, 67a Reference surface (Mounting surface, Top surface)
29a Suction part
35 Exposure apparatus
36a3 Coating device
36a4 Developing device
68 Divided reference member
68a Divided correction surface
76 Holding part
80 Holding piece
200 Wafer
203 First surface (Bottom surface)
204 Second surface (Top surface)
205 Side surface
D1 First orthogonal direction (Second direction)
D2 Second orthogonal direction (Third direction)
D3 Thickness direction (First direction)

## Claims

1. A correction apparatus comprising:
a mounting device configured to allow a wafer to be mounted thereon;
a heating part configured to heat the wafer mounted on the mounting device;
a force application part configured to apply a force to the wafer mounted on the mounting device;
a first transport device configured to transport the wafer removed from the mounting device; and
a controller configured to control the heating part and the force application part,
wherein the controller performs shape correction on the wafer by the force application part applying a force to the wafer while the heating part heats the wafer, and
the first transport device transports the wafer to which the shape correction has been performed.

2. The correction apparatus according to claim 1,
wherein the shape correction makes a warpage of the wafer transported by the first transport device smaller than a warpage of the wafer before being mounted on the mounting device.

3. The correction apparatus according to claim 1 or 2,
wherein the shape correction makes a shape of the wafer transported by the first transport device closer to a flat shape than the shape of the wafer before being mounted on the mounting device.

4. The correction apparatus according to any one of claims 1 to 3,
wherein the first transport device transports the wafer, to which the shape correction has been performed, to a coating device capable of coating a photosensitive agent on the wafer.

5. The correction apparatus according to any one of claims 1 to 4, further comprising:
a cooling part configured to cool the wafer to which the shape correction has been performed.

6. The correction apparatus according to claim 5,
wherein the cooling part cools the wafer, to which the shape correction has been performed, while the wafer is mounted on the mounting device.

7. The correction apparatus according to any one of claims 1 to 6,
wherein the controller performs shape correction on the wafer by causing the force application part to apply a force to the wafer so that the wafer is aligned with a mounting surface of the mounting device.

8. The correction apparatus according to any one of claims 1 to 7,
wherein the mounting device includes a reference member having a reference surface, and
the controller causes the force application part to apply a force to the wafer so that the wafer is aligned with the reference surface, thereby performing the shape correction on the wafer.

9. The correction apparatus according to claim 8,
wherein the reference member includes a plurality of divided reference members having a plurality of divided correction surfaces constituting the reference surface,
the correction apparatus further comprises a moving part configured to move the plurality of divided reference members in a first direction independently from each other, and
the force application part is provided for each of the divided correction surfaces of the plurality of divided reference members.

10. The correction apparatus according to any one of claims 1 to 9,
wherein the heating part heats the mounting device, thereby heating the wafer.

11. The correction apparatus according to any one of claims 1 to 10,
wherein the controller starts heating of the mounting device by the heating part before the wafer comes into contact with the mounting device.

12. The correction apparatus according to any one of claims 1 to 11,
wherein a bottom surface of the wafer and a top surface of the mounting device come into contact with each other, and
the force application part applies a force to the wafer from the top surface side of the wafer.

13. The correction apparatus according to any one of claims 1 to 11,
wherein a bottom surface of the wafer and a top surface of the mounting device come into contact with each other, and
the force application part applies a force to the wafer from the bottom surface side of the wafer.

14. The correction apparatus according to any one of claims 1 to 13,
wherein the force application part contains a suction part, and
the suction part performs the shape correction on the wafer by sucking the wafer from a bottom surface side of the wafer.

15. The correction apparatus according to any one of claims 1 to 11, further comprising:
a measurement part configured to measure a shape of the wafer,
wherein the controller measures the shape of the wafer using the measurement part before the shape correction is performed on the wafer.

16. The correction apparatus according to claim 15,
wherein the controller measures a shape of the wafer using the measurement part after the shape correction is performed on the wafer.

17. The correction apparatus according to claim 15 or 16,
Wherein, when an amount of warping of the wafer measured by the measurement part is equal to or greater than a predetermined warpage threshold value, the controller causes the force application part to apply a force to the wafer while the heating part heats the wafer.

18. The correction apparatus according to any one of claims 1 to 14,
wherein a shape of a mounting surface of the mounting device on which the wafer is mounted is a shape of a recess or a convex part.

19. The correction apparatus according to any one of claims 1 to 14,
wherein a shape of a mounting surface of the mounting device on which the wafer is mounted is designed on the basis of deformation caused by a reaction force after the force application part applies a force to the wafer so that the wafer is aligned with the mounting surface, and then the application of the force to the wafer is stopped.

20. The correction apparatus according to any one of claims 1 to 19,
wherein the controller controls at least one of a time over which a force is applied, an amount of the force, a position to which the force is applied, and a manner of applying the force to the wafer by the force application part.

21. The correction apparatus according to any one of claims 1 to 20,
wherein the controller controls at least one of a position, a time, and an amount of heating of the wafer by the heating part.

22. The correction apparatus according to any one of claims 1 to 21,
wherein the force application part applies a force to the wafer by coming into contact with the wafer mounted on the mounting device.

23. The correction apparatus according to any one of claims 1 to 22,
wherein the force application part applies a force to the wafer mounted on the mounting device without coming into contact with the wafer.

24. The correction apparatus according to any one of claims 1 to 23,
wherein a shape of the wafer is a three-dimensional shape of the wafer.

25. A correction apparatus comprising:
a mounting device configured to allow a wafer to be mounted thereon;
a heating part configured to heat the wafer mounted on the mounting device; and
a force application part configured to apply a force to the wafer,
wherein the force application part applies a force to the wafer so that the wafer is aligned with the mounting device while the heating part heats the wafer, thereby correcting a shape of the wafer.

26. A correction apparatus comprising:
a measurement part configured to measure a three-dimensional shape of a wafer;
a holding part configured to hold a center of the wafer;
a heating part configured to heat the wafer;
a force application part configured to apply a force to an outer periphery of the wafer in a first direction; and
a controller configured to control the heating part and the force application part,
wherein the controller causes the force application part to apply a force to the outer periphery of the wafer on the basis of the three-dimensional shape measured by the measurement part while the heating part heats the wafer, thereby deforming the wafer.

27. A correction apparatus comprising:
a measurement part configured to measure a three-dimensional shape of a wafer;
a holding part configured to hold a first portion of the wafer;
a heating part configured to heat the wafer;
a force application part configured to apply a force to deform a second portion of the wafer that is outside the first portion in a first direction; and
a controller configured to control the heating part and the force application part,
wherein the controller applies a force to the wafer by causing the force application part to apply a force to the second portion of the wafer on the basis of the three-dimensional shape measured by the measurement part while the heating part heats the wafer.

28. The correction apparatus according to claim 26 or 27,
wherein the controller measures the shape of the wafer using the measurement part before a force is applied to the wafer.

29. The correction apparatus according to any one of claims 26 to 28,
wherein the controller measures a shape of the wafer using the measurement part after the wafer is deformed, and
when an amount of warping of the wafer measured by the measurement part is equal to or greater than a predetermined warpage threshold value, the force application part applies a force to the wafer while the heating part heats the wafer.

30. The correction apparatus according to any one of claims 25 to 27, further comprising:
a cooling part configured to cool the corrected wafer.

31. A correction apparatus comprising:
a holding part configured to hold a front surface, a back surface, or a side surface of a wafer;
a heating part configured to heat the wafer; and
a force application part configured to apply a force to the wafer via the holding part to deform the wafer.

32. The correction apparatus according to claim 31,
wherein the holding part has a plurality of holding pieces that hold the side surface of the wafer while being divided in a circumferential direction of the wafer, and
the force application part applies a bending moment to the wafer via the plurality of holding pieces.

33. The correction apparatus according to claim 31 or 32,
wherein the force application part deforms a first surface of the wafer facing a first direction of the wafer.

34. The correction apparatus according to any one of claim 31 to 33, further comprising:
a measurement part configured to measure a shape of the wafer; and
a controller configured to control the heating part and the force application part,
wherein the controller applies a force to the wafer by causing the force application part to apply a force to the wafer via the holding part on the basis of the shape measured by the measurement part while the heating part heats the wafer.

35. The correction apparatus according to claim 34,
wherein the controller causes the measurement part to measure a shape of the wafer after the wafer is corrected, and
when an amount of warping of the wafer measured by the measurement part is equal to or greater than a predetermined warpage threshold value, the force application part applies a force to the wafer via the holding part while the heating part heats the wafer.

36. The correction apparatus according to any one of claims 31 to 35, further comprising:
a cooling part configured to cool the deformed wafer.

37. A correction apparatus comprising:
a measurement part configured to measure a shape of a wafer;
a heating part configured to heat the wafer;
a force application part configured to apply a force to the wafer by applying a force to the wafer; and
a controller configured to control the heating part and the force application part,
wherein the controller performs control so that the force application part applies different forces at different positions on the surface of the wafer on the basis of the shape of the wafer measured by the measurement part while the heating part heats the wafer, or performs control so that the force application part applies forces with different pushing amounts at different positions on the surface of the wafer.

38. A correction apparatus comprising:
a reference member that has a reference surface;
a heating part configured to heat a wafer; and
a force application part configured to apply a force to the wafer by applying a force to the wafer so that the wafer is aligned with the reference surface.

39. A correction apparatus comprising:
a holding part configured to hold a center of a wafer;
a heating part configured to heat the wafer; and
a force application part configured to apply a force to the wafer by applying a force to the outer periphery of the wafer in a first direction of the wafer.

40. A correction apparatus comprising:
a holding part configured to hold a side surface of a wafer in a first direction;
a heating part configured to heat the wafer; and
a force application part configured to apply a force to the wafer by applying a force to the wafer.

41. The correction apparatus according to any one of claims 1 to 40,
wherein the wafer has a smaller dimension in a fourth direction, which is along a direction that intersects with a second direction and a third direction, compared to a dimension in the second direction and the third direction that intersect with each other.

42. An exposure system comprising:
the correction apparatus according to any one of claims 1 to 41;
a coating device capable of coating a photosensitive agent on a wafer; and
an exposure apparatus configured to expose a wafer coated with the photosensitive agent using an energy beam.

43. The exposure system according to claim 42, further comprising:
a developing device,
wherein the developing device develops the wafer exposed by the exposure apparatus.

44. The exposure system according to claim 42 or 43,
wherein the exposure apparatus includes a second transport device that transports the wafer within the exposure apparatus, and
the correction apparatus corrects a shape of the wafer so that the second transport device is able to transport the wafer.

45. An exposure apparatus comprising:
the correction apparatus according to any one of claims 1 to 41; and
a projection optical system configured to project exposure light to the wafer whose shape has been corrected using the correction apparatus.

46. A coater and developer apparatus comprising:
the correction apparatus according to any one of claims 1 to 41; and
a coating device capable of coating a photosensitive agent on the wafer whose shape has been corrected using the correction apparatus.

47. An exposure method of exposing a wafer using an energy beam comprising:
exposing the wafer whose shape has been corrected by the correction apparatus according to any one of claims 1 to 41 using the energy beam.

48. A device manufacturing method comprising an exposure step,
wherein the exposure step includes developing the wafer exposed using the exposure system according to any one of claims 42 to 44.
